# FASCICULE DE BREVET EUROPEEN

(11) **EP 2 001 126 B1**
(45) Date de publication et mention de la délivrance du brevet: **04.08.2010**
(21) Numéro de dépôt: 08156595.4
(22) Date de dépôt: 20.05.2008
(51) Int. Cl.: H03D 7/16, H04B 1/44

(54) **Mélangeur bidirectionnel de fréquences, système émetteur/récepteur radiofréquences comportant au moins un tel mélangeur**
Bidirektionaler Frequenzmischer sowie Sender-Empfänger-System für Funkfrequenzen, das mindestens einen solchen Mischer umfasst
Bidirectional frequency mixer, radiofrequency emitter/receiver system comprising at least one such mixer

(30) Priorité: 25.05.2007 FR 0703731
(43) Date de publication de la demande: 10.12.2008
(73) Titulaire: THALES, 92200 Neuilly sur Seine (FR)
(72) Inventeur: Teillet, Hervé, 94700 Maisons Alfort (FR); Guillerme, Yves, 91400 Saclay (FR); Hassen-Khodja, Rafik, 95490 Vauréal (FR)
(74) Mandataire: Lucas, Laurent Jacques

(56) Documents cités:
- JP-A- 57 069 939
- US-A- 5 590 412
- US-A- 5 590 413
- US-B1- 6 226 509

## Description

La présente invention concerne un mélangeur bidirectionnel de fréquences, ainsi qu'un système émetteur/récepteur radiofréquences comportant au moins un tel mélangeur. Elle s'applique notamment dans la conception de circuits intégrés hyperfréquence, particulièrement en bande de fréquences millimétrique.

Les systèmes de communications radiofréquences comportent généralement des dispositifs de réception et d'émission tels que des antennes, une unité de traitement, ainsi qu'une interface permettant les échanges de signaux entre les dispositifs d'émission/réception et l'unité de traitement.

Afin d'une part, de rendre exploitable par une unité de traitement un signal reçu par le dispositif d'émission/réception, et d'autre part de pouvoir émettre un signal produit par l'unité de traitement, les fonctions de réception et d'émission comportent généralement des étapes d'amplification, de filtrage, de mélange et de modulation/démodulation. Les mélangeurs sont, entre autre, utilisés pour transposer des signaux hautes fréquences à des bandes de fréquences plus faibles afin de faciliter les traitements. En particulier, l'emploi de certains filtres, calculateurs ou démodulateurs nécessitent parfois de travailler à des fréquences moins élevées, dites fréquences intermédiaires.

Un des problèmes posés par les systèmes de communications est l'émission/réception simultanée, ou au moins l'émission/réception en mode semi-duplex. En particulier, une difficulté supplémentaire apparaît avec l'utilisation des mélangeurs. Il apparaît en effet des signaux de fréquences indésirables engendrés lors d'un mélange, que ce soit en phase de réception ou en phase d'émission.

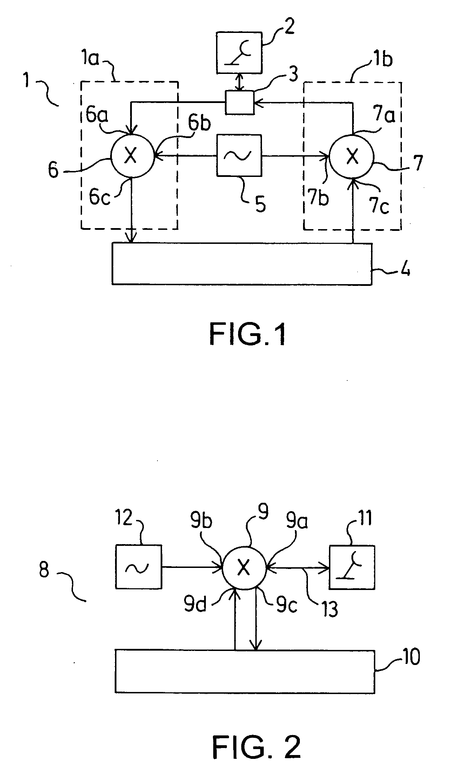

Afin de répondre à ces problèmes, il est connu d'utiliser une chaîne émettrice de signaux séparée de la chaîne réceptrice, comme le montre la figure 1. Chacune de ces deux chaînes de traitement comporte alors ses propres composants et peut fonctionner sans perturber de manière significative la chaîne concomitante. Une telle structure présente notamment comme inconvénient d'augmenter le coût et la taille du circuit. En particulier, au moins deux mélangeurs 6. 7 sont nécessaires, l'un pour la phase de réception qui convertit les signaux hautes fréquences vers une fréquence intermédiaire et l'autre pour la phase d'émission qui convertit les signaux issus de l'unité de traitement vers une fréquence plus élevée. En bande de fréquences millimétrique, ces éléments peuvent notamment être intégrés sur un circuit intégré hyperfréquence appelé encore MMIC selon l'expression anglo-saxonne « Monolithic Microwave Integrated Circuit ». Or, le nombre et la taille des composants à intégrer sur ce type de circuits est un critère important à prendre en compte dans la phase de conception.

La figure 1 présente un système émetteur/récepteur radiofréquences selon l'art antérieur. Le système 1 comporte une antenne 2, d'un dispositif de commutation 3, d'une unité de traitement 4, d'un oscillateur local 5 et de deux mélangeurs 6 et 7.

En phase de réception, un signal S_{RF} de fréquence RF capté par l'antenne 2 est transmis par le dispositif de commutation 3 vers une première entrée 6a du premier mélangeur 6. En combinant le signal S_{RF} avec un signal de fréquence F_{OL} fourni sur une deuxième entrée 6b par l'oscillateur local 5, le premier mélangeur 6 produit un signal S_{FI} sur une sortie 6c à une fréquence intermédiaire FI compatible avec le fonctionnement de l'unité de traitement 4.

En phase d'émission, l'unité de traitement 4 fournit sur une première entrée 7c du deuxième mélangeur 7 un signal S_{FI} de fréquence FI. En combinant le signal S_{FI} avec un signal de fréquence F_{OL} fourni par l'oscillateur local 5 sur une deuxième entrée 7b, le deuxième mélangeur 7 produit sur une sortie 7a un signal S_{RF} de fréquence RF. Le signal S_{RF} est ensuite transmis par commutation 3 à l'antenne 2 qui peut l'émettre.

Le brevet américain référencé US5590412 et issu d'une demande déposée pour Sanyo Electric Co présente un mélangeur bidirectionnel de signaux.

Un but de l'invention est notamment d'utiliser un seul mélangeur commun aux chaînes d'émission et de réception effectuant une réjection des fréquences indésirables en phase de réception et en phase d'émission. A cet effet, l'invention a pour objet un mélangeur de signaux bidirectionnel adapté à fonctionner selon deux modes :
o un mode réception, combinant un signal radioélectrique S_{RF+IM} comprenant une composante fréquentielle RF et une composante fréquentielle image IM avec un signal S_{FOL} de fréquence F_{OL} pour produire un signal S_{FI} de fréquence intermédiaire FI,
o un mode émission, combinant un signal S_{FI} de fréquence intermédiaire FI avec un signal S_{FOL} de fréquence F_{OL} pour produire un signal radioélectrique S_{RF},
le mélangeur comportant au moins :
o quatre cellules de mélange, chacune étant adaptée à combiner deux signaux pour produire un signal de sortie transposé en fréquences par rapport au premier des deux signaux,
o un premier moyen de déphasage adapté à répartir le signal S_{FOL} sur chaque cellule de mélange,
o un deuxième moyen de déphasage adapté, en réception, à répartir la puissance du signal S_{RF+IM} sur chaque cellule de mélange,
o un troisième moyen de déphasage adapté, en réception, à combiner les signaux issus desdites cellules de mélange pour produire un signal S_{FI} exempt de la composante fréquentielle IM, les signaux combinés comprenant des composantes fréquentielles image IM en opposition de phase et des composantes fréquentielles FI en phase,
le troisième moyen de déphasage étant également adapté, en émission, à répartir la puissance du signal S_{FI} sur chaque cellule de mélange, et, le deuxième moyen de déphasage étant également adapté, en émission, à combiner les signaux issus desdites cellules de mélange pour produire un signal radioélectrique S_{RF} exempt de la composante fréquentielle F_{OL}, les signaux combinés comprenant des composantes fréquentielles F_{OL} en opposition de phase et des composantes fréquentielles RF en phase.

Selon un mode de réalisation, le premier moyen de déphasage comporte au moins un coupleur adapté à répartir la puissance d'un signal d'entrée sur deux signaux de sortie, le premier signal de sortie S_{FOL}^{90°} étant déphasé par rapport au second signal de sortie S_{FOL}^{0°}.

Le premier moyen de déphasage peut comporter un diviseur de puissance et deux coupleurs, ledit diviseur répartissant la puissance du signal S_{FOL} sur une entrée de chaque coupleur, chaque coupleur répartissant la puissance de son signal entrant sur deux signaux de sortie, le premier signal de sortie S_{FOL}^{90°} étant déphasé par rapport au second signal S_{FOL}^{0°} de sortie.

Le deuxième moyen de déphasage peut comporter au moins trois coupleurs, une première entrée-sortie du premier coupleur étant reliée à une entrée-sortie du deuxième coupleur, et une deuxième entrée-sortie du premier coupleur étant reliée à une entrée-sortie du troisième coupleur, les deuxième et troisième coupleur étant reliés aux cellules de mélange, de manière :
o à répartir, en sortie des deuxième et troisième coupleur, la puissance du signal S_{RF+IM} reçu par une entrée-sortie du premier coupleur,
o et/ou à combiner les signaux reçus par les deuxième et troisième coupleur pour produire un signal S_{RF} sur une entrée-sortie du premier coupleur.

Le troisième moyen de déphasage peut comporter au moins trois coupleurs, une première entrée-sortie du premier coupleur étant reliée à une entrée-sortie du deuxième coupleur, et une deuxième entrée-sortie du premier coupleur étant reliée à une entrée-sortie du troisième coupleur, les deuxième et troisième coupleur étant reliés aux cellules de mélange, de manière
o à répartir, en sortie des deuxième et troisième coupleur, la puissance du signal S_{FI} reçu par une entrée-sortie du premier coupleur,
o et/ou à combiner des signaux reçus par les deuxième et troisième coupleur pour produire un signal S_{FI} sur une entrée-sortie du premier coupleur.

L'invention concerne également un système émetteur/récepteur radiofréquences comportant au moins un mélangeur bidirectionnel comprenant les caractéristiques décrites plus haut.

D'autres caractéristiques et avantages apparaîtront à la lecture de la description détaillée illustrative et non limitative qui suit faite en regard de dessins annexés qui représentent :
- la figure 1, un système émetteur/récepteur radiofréquences selon l'art antérieur, la figure a déjà été présentée,
- la figure 2, un système émetteur/récepteur radiofréquences comportant un mélangeur bidirectionnel de fréquences selon l'invention,
- la figure 3, un exemple de réalisation d'un mélangeur selon l'invention avec des indications fléchées sur les sens de propagation des signaux correspondant à la phase de réception,
- la figure 4, un exemple de réalisation d'un mélangeur selon l'invention avec des indications fléchées sur les sens de propagation des signaux correspondant à la phase d'émission,
- la figure 5 un exemple d'utilisation du mélangeur selon l'invention.

La figure 2 présente un système émetteur/récepteur d'un mélangeur 9 bidirectionnel, selon l'invention, permettant la conversion des signaux en phase de réception et en phase d'émission.

Un système 8, dont le fonctionnement détaillé est décrit ci-après, opère selon un mode semi-duplex. Le système 8 comprend le mélangeur 9 bidirectionnel, un dispositif de traitement de signal 10, une antenne 11 et un oscillateur local 12 fournissant une fréquence de transposition. Le mélangeur 9 comporte une première entrée 9b, une deuxième entrée 9d, une entrée-sortie 9a et une sortie 9c. Le système 8 fonctionne par exemple de la manière décrite ci-après.

Pendant une période de temps Δt1, le système 8 fonctionne en mode réception, c'est à dire que l'antenne 11 capte des signaux extérieurs. Ces signaux sont transmis vers le mélangeur 9, puis à l'unité de traitement 10. Lorsque la période Δt1 est terminée, l'antenne 11 bascule en mode émission pour une durée Δt2, par exemple. Le mélangeur 9 ne comporte pas nécessairement de dispositif de commutation pour passer d'un mode à l'autre. La présence ou l'absence de signaux sur l'entrée-sortie 9a suffit, dans l'exemple, à définir le mode de fonctionnement. Les signaux issus de l'unité de traitement 10, sont alors transmis vers le mélangeur 9 puis vers l'antenne 11 qui émet. Lorsque la période Δt2 est terminée, l'antenne 11 bascule de nouveau en mode réception pour une durée Δt1 et le cycle recommence.

Le mélangeur 9 est qualifié de bidirectionnel au sens où il peut opérer une transposition en fréquence dans les deux sens, c'est à dire convertir des signaux d'une fréquence A vers une fréquence B et de la fréquence B vers la fréquence A.

En phase de réception, le mélangeur bidirectionnel 9 reçoit sur l'entrée-sortie 9a un signal S_{RF} de fréquence RF provenant du dispositif de l'antenne 11, et sur la première entrée 9b un signal S_{Fol} de fréquence Fol produit par l'oscillateur local 12. Le rôle du mélangeur 9 est alors de convertir le signal S_{RF} vers un signal S_{FI} délivré par la sortie 9c, de fréquence intermédiaire réduite FI égale à |RF-Fol|. Par exemple, un mélangeur peut être utilisé dans un émetteur/récepteur radiofréquences, lequel reçoit une onde porteuse à une fréquence RF égale à 40 Ghz et doit transposer ce signal à une fréquence intermédiaire FI égale à 5 Ghz. Dans ce cas de figure, l'oscillateur local délivre un signal de fréquence RF-FI égale à 35 Ghz ou de fréquence RF+FI égale à 45 Ghz. Dans l'exemple de réalisation développé dans cette description, la fréquence de transposition Fol est choisie inférieure à RF et donc Fol=RF-Fl.

Or, le signal d'entrée S_{RF} peut être bruité. Il peut notamment contenir une composante fréquentielle parasite à la fréquence IM égale à Fol-FI, c'est ce que l'homme du métier nomme communément la fréquence image. Comme le mélangeur 9 agit sur une large bande du spectre de fréquences, ce bruit S_{IM} à la fréquence IM peut être transposé à la fréquence |IM-Fol| égale à FI et perturber le signal issu de la sortie 9c en s'ajoutant au signal utile. Un mélangeur 9 selon l'invention effectue une réjection de la fréquence image IM et le signal issu de la sortie 9c est alors composé de deux composantes fréquentielles principales : FI et Fol. La fréquence Fol indésirable peut être aisément filtrée car elle est généralement beaucoup plus élevée que FI.

En phase d'émission, le mélangeur 9 reçoit sur la deuxième entrée 9d un signal S_{FIT} de fréquence FI et sur la première entrée 9b un signal S_{FOL} de fréquence Fol qui peut être produit par le même oscillateur local 12 que pour la phase de réception. Le rôle du mélangeur 9 est alors de convertir le signal S_{FIT} vers un signal de fréquence plus élevée RF sortant sur l'entrée-sortie 9a. C'est ensuite l'antenne 11 qui émet ce signal.

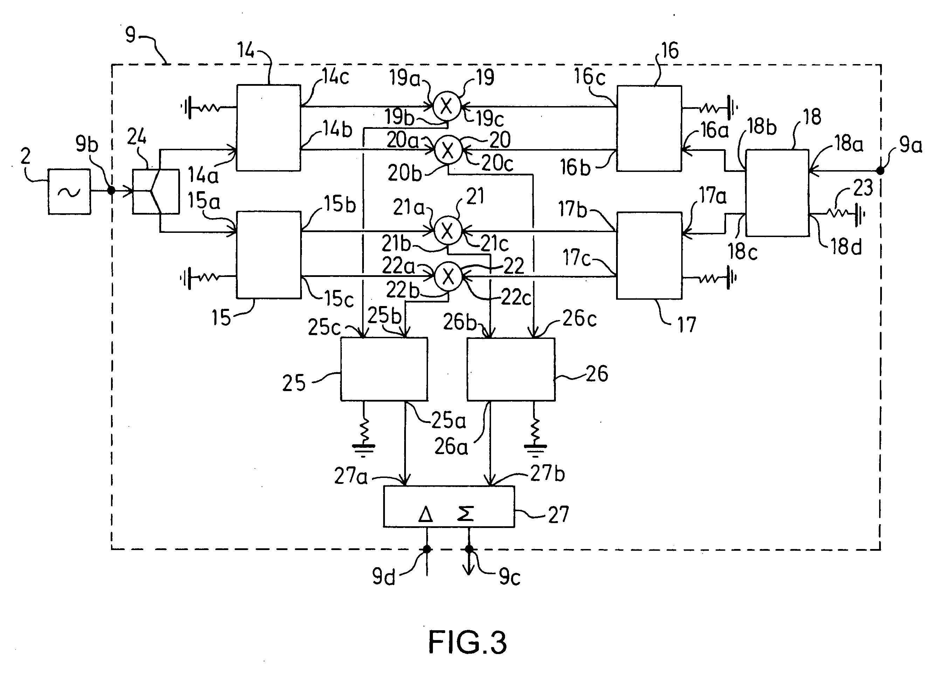

Le mélangeur 9 utilise un signal S_{Fol} généralement de forte puissance afin d'effectuer une transposition fréquentielle pour l'émission. Comme il sera décrit plus loin, un mélangeur peut transmettre en sortie, une partie de la puissance aux fréquences d'entrée. Or, il faut éviter de transmettre la composante Fol par l'entrée-sortie 9a, car Fol étant relativement proche de RF, et d'autant plus proche de RF que FI sera petit, il serait ensuite difficile d'éliminer cette fréquence Fol par filtrage. Selon une méthode décrite après en relation avec la figure 3, le mélangeur 9 opère donc une réjection de la fréquence Fol et le signal issu de l'entrée-sortie 9a est alors composé de la seule composante fréquentielle RF.

Selon un autre mode de fonctionnement, le système 8 comprend deux antennes, une première pour l'émission et une seconde pour la réception des signaux. Dans ce cas, la liaison 13 peut être scindée, par exemple à l'aide d'un diviseur de puissance, une entrée du diviseur de puissance étant reliée à la première antenne et une autre entrée étant reliée à la seconde antenne. Ce mode de réalisation n'est pas représenté sur les figures.

Des moyens de filtrage ou amplificateurs, ici non représentés, peuvent également être placés sur les voies reliant le mélangeur 9 aux autres éléments 10, 11 et 12 du système 8.

La figure 3 présente un exemple de réalisation de l'invention avec des indications fléchées représentant les sens de propagation des signaux correspondant à la phase de réception.

Le mélangeur 9 bidirectionnel peut être réalisé par l'emploi d'éléments passifs tels qu'un premier coupleur 14, un deuxième coupleur 15, un troisième coupleur 16, un quatrième coupleur 17, un cinquième coupleur 18, un sixième coupleur 25, un septième coupleur 26 et un huitième coupleur 27 mais également grâce à des éléments actifs comme une première cellule de mélange 19, une deuxième cellule de mélange 20, une troisième cellule de mélange 21 et une quatrième cellule de mélange 22.

Le cinquième coupleur 18 comporte une première entrée-sortie 18a, une deuxième entrée-sortie 18b, une troisième entrée-sortie 18c, et une quatrième entrée-sortie 18d. Le signal entrant par la première entrée-sortie 18a est réparti en puissance sur les entrées-sorties 18b et 18c. Sur la troisième entrée-sortie 18c, le signal sort déphasé de 90°, tandis qu'il est transmis en ligne directe et donc sans déphasage vers la deuxième entrée-sortie 18b. La quatrième entrée-sortie 18d est simplement liée à une charge résistive 23. Les autres coupleurs 14, 15, 16, 17, 25 et 26, à l'exception du huitième coupleur 27 fonctionnent de manière analogue en effectuant un déphasage de 90°. Le huitième coupleur 27 comprend quatre entrées-sorties, une première entrée-sortie 27a, une deuxième entrée-sortie 27b, une troisième entrée-sortie 9c et une quatrième entrée-sortie 9d. Lorsque deux signaux entrent respectivement par la première entrée-sortie 27a et la deuxième entrée-sortie 27b, leurs puissances sont combinées pour sortir sur la troisième entrée-sortie 9c. Lorsqu'un signal est reçu par la quatrième entrée-sortie 9c, il est réparti en puissance sur les première et deuxième entrées-sorties 27a, 27b. Le signal issu alors de la première entrée-sortie 27a est déphasé de 180° tandis que le signal issu de la deuxième entrée-sortie 27b n'est pas déphasé.

Une première cellule de mélange 19 comprend un premier accès 19a, un deuxième accès 19b, et un troisième accès 19c. Elle a notamment pour fonction de combiner deux signaux d'entrée de fréquences respectives A et B pour produire un signal en sortie comportant les composantes fréquentielles suivantes A, B, A+B et |A-B|. Ce sont ici les composantes fréquentielles A+B et |A-B| qui sont utiles, car ce sont celles qui permettent de transposer une fréquence d'entrée vers une autre fréquence plus basse, par exemple pour la réception, ou plus élevée, par exemple pour l'émission. Les composantes indésirables peuvent, par exemple, être filtrées en sortie. Dans le cadre du fonctionnement décrit ici, le premier accès 19a reste une entrée tandis que les deux autres accès 19b et 19c fonctionnent en opposition et deviennent alternativement une entrée ou une sortie de la cellule 19 selon que le mélangeur 9 est en mode réception ou émission. Les autres cellules de mélange 20, 21, et 22 présentées par la suite fonctionnent de manière analogue.

En phase de réception, le signal d'entrée S_{RF} passe dans le cinquième coupleur 18 qui génère un signal S_{RF}^{90°} de même fréquence déphasé de 90° sur sa troisième entrée-sortie 18c, tandis que sa deuxième entrée-sortie 18b produit un signal S_{RF}^{0°} de même fréquence et de même phase que S_{RF}. Par ailleurs, le signal d'entrée S_{RF} peut contenir des bruits autour de la fréquence image IM=Fol-FI. Un bruit S_{IM} sur cette fréquence est potentiellement gênant car il est transposé par une cellule de mélange à la fréquence intermédiaire FI, parasitant ainsi le signal utile. Un signal bruité S_{RF}+S_{IM} est donc transmis dans le premier coupleur 18 et les signaux S_{RF}^{0°}+S_{IM}^{0°} et S_{RF}^{90°}+S_{IM}^{90°} sortent de ce coupleur respectivement par sa deuxième 18b et sa troisième entrée-sortie 18c. Suivant le même principe, les signaux S_{RF}^{0°}+S_{IM}^{0°} et S_{RF}^{90°}+S_{IM}^{90°} passent respectivement dans les troisième et quatrième coupleurs 16 et 17 via les premières entrées-sorties 16a et 17a pour subir un déphasage de 90°. Ainsi, les deuxièmes et troisièmes entrées-sorties 16c, 16b, 17b et 17c des troisième et quatrième coupleurs 16 et 17produisent toutes un signal à la fréquence RF bruité, mais chacun avec leur déphasage propre. Les signaux S_{RF}^{90°}+S_{IM}^{90°} issus de la troisième entrée-sortie 16c du troisième coupleur 16et de la deuxième entrée-sortie 17b du quatrième coupleur 17 sont déphasés de 90°, le signal S_{RF}^{0°}+S_{IM}^{0°} issu de la deuxième entrée-sortie 16b du troisième coupleur 16 n'est pas déphasé et le signal S_{RF}^{180°}+S_{IM}^{180°} issu de la troisième entrée-sortie17c du quatrième coupleur 17 est déphasé de 180°.

De même, le signal S_{FOL} produit par l'oscillateur local 12 est transmis aux premier et deuxième coupleurs 14 et 15 après être passé par un diviseur de puissance 24 pour répartir le signal vers leurs deux premières entrées-sorties 14a et 15a. Suivant le même principe que pour les troisième et quatrième coupleurs 16 et 17, les signaux sortant des premier et deuxième coupleurs 14 et 15 sont de même fréquence Fol mais de phases différentes. Les signaux S_{FOL}90° issus des troisièmes entrées-sorties 14c et 15c des premier et deuxième coupleurs 14 et 15 sont déphasés de 90° tandis que les signaux S_{FOL}^{0°} issus des deuxièmes entrées-sorties 14b et 15b des premier et deuxième coupleurs 14 et 15 ne sont pas déphasés.

Selon un autre mode de réalisation, les signaux S_{FOL}^{0°} et S_{FOL}^{90°} produits en sortie des premier et deuxième coupleurs 14 et 15 sont produits en utilisant un seul coupleur recevant le signal S_{FOL} produit par l'oscillateur local 12. Un diviseur de puissance est alors placé à chacune des deux sorties dudit coupleur pour répartir la puissance des deux signaux S_{FOL}^{0°} et S_{FOL}^{90°} en quatre signaux de puissances sensiblement égales. Ces quatre signaux sont alors répartis en sortie de manière à présenter successivement les mêmes déphasages que ceux produits par le mode de réalisation précédent, impliquant deux coupleurs.

Les signaux entrant sur les premiers et troisièmes accès (19a et 19c), (20a et 20c), (21 a et 21 c), (22a et 22c) de chaque cellule de mélange 19, 20, 21 et 22 produisent les combinaisons suivantes:
o S_{FOL}^{90°} avec S_{RF}^{90°}+S_{IM}^{90°} sur la première cellule de mélange 19,
o S_{FOL}^{0°} avec S_{RF}^{0°}+S_{IM}^{0°} sur la deuxième cellule de mélange 20,
o S_{FOL}^{0°} avec S_{RF}^{90°}+S_{IM}^{90°} sur la troisième cellule de mélange 21,
o S_{FOL}^{90°} avec S_{RF}^{180°}+S_{IM}^{180°} sur la quatrième cellule de mélange 22.
Selon le fonctionnement d'une cellule de mélange décrit plus haut, les composantes fréquentielles en sortie des cellules de mélange sont Fol, RF, IM, RF+Fol, IM+Fol, et FI=RF-Fol=Fol-IM. Les composantes Fol, RF, IM, et RF+Fol sont indésirables mais peuvent être filtrées aisément ultérieurement du fait de l'écart de valeur important entre ces fréquences et FI. Afin de rendre le propos plus clair, ces composantes, bien que potentiellement présentes dans le spectre de fréquence, seront donc ignorées dans la suite de la description. La composante fréquentielle FI est issue à la fois de RF-Fol et de Fol-IM, donc le spectre de fréquence en sortie est parasité par un signal créé par la transposition de la fréquence IM. Il faut donc supprimer ce signal parasite.
Un signal S_{FI}^{90°} de fréquence FI issu du deuxième accès 21 b de la troisième cellule de mélange 21 est le produit de la transposition du signal S_{RF}^{90°} déphasé de 90° et de fréquence RF par le signal S_{FOL}^{0°} de fréquence Fol. Le bruit S_{IM}^{90°} de fréquence image IM est également transposé en signal S_{FI/IM}^{-90°} de fréquence FI. Mais ce signal S_{FI/IM}^{-90°} est en opposition de phase par rapport au signal S_{FI}^{90°} issu de la composante RF. Pour rappel, IM=Fol-FI et donc IM-Fol=-FI tandis que RF-Fol=Fl. En sortie du deuxième accès 21 b de la troisième cellule de mélange 21, il existe donc un signal de fréquence FI S_{FI}^{90°}+S_{FI/IM}^{-90°}. De manière similaire, la quatrième cellule 22 traite des signaux d'entrée S_{FOL}^{90°} et S_{RF}^{180°}+S_{IM}^{180°} déphasés entre eux de 90°, donc le signal issu du deuxième accès 22b de la quatrième cellule de mélange 22 est le même que celui issu de 21 b. Pour les première et deuxième cellules 19 et 20, les signaux d'entrée S_{FOL}^{90°} et SRF^{90°}+S_{IM}^{90°} d'une part, et S_{FOL}^{0°} et S_{RF}^{0°}+S_{IM}^{0°} d'autre part ne sont pas déphasés entre eux. Aux sorties des deuxièmes accès 19b et 20b des première et deuxième cellules de mélange, on retrouve donc des signaux non déphasés S_{FI}^{0°}+S_{FI/IM}^{0°}.

Les signaux issus des deuxièmes accès 19b et 22b des première et quatrième cellules de mélange 19 et 22 sont recombinés dans le sixième coupleur 25 et les signaux issus des deuxièmes accès 20b et 21 b des deuxième et troisième cellules de mélange 20 et 21 sont recombinés dans le septième coupleur 26.

Ainsi, le sixième coupleur 25 reçoit le signal S_{FI}^{0°}+S_{FI/IM}^{0°} issu du deuxième accès 19b de la première cellule de mélange par sa troisième entrée-sortie 25c et il reçoit le signal S_{FI}^{90°}+S_{FI/IM}^{-90°} issu du deuxième accès 22b de la quatrième cellule de mélange par sa deuxième entrée-sortie 25b. De même, le signal S_{FI}^{0°}+S_{FI/IM}0° issu du deuxième accès 20b de la deuxième cellule de mélange 20 entre dans le septième coupleur 26 par sa troisième entrée-sortie 26c et le signal S_{FI}^{90°}+S_{FI/IM}^{-90°} issu du deuxième accès 21 b de la troisième cellule de mélange entre par sa deuxième entrée-sortie 26b. Les signaux entrant par les troisièmes entrées-sorties 25c et 26c des sixième et septième coupleurs sont déphasés de 90°. Ainsi, les combinaisons suivantes sont effectuées :
o pour le sixième coupleur 25, S_{FI}^{0°+90°}+S_{FI/IM}^{0°+90°} (troisième entrée-sortie 25c déphasée) avec S_{FI}^{90°}+S_{FI/IM}^{-90°} (deuxième entrée-sortie 25b non déphasée),
o pour le septième coupleur 26, S_{FI}^{0°+90°}+S_{FI/IM}^{0°+90°} (troisième entrée-sortie 26c déphasée) avec S_{FI}^{90°}+S_{FI/IM}^{-90°} (deuxième entrée-sortie 26b non déphasée).
Les puissances entre les entrées étant sensiblement également réparties, c'est donc le signal S_{FI}^{0°+90°}+S_{FI/IM}^{0°+90°}+S_{FI}^{90°}+SFI/IM^{-90°}=S_{FI}^{90°} qui sort de la première entrée-sortie 25a du sixième coupleur avec une puissance en sortie double que le signal S_{FI}^{90°} entré par la deuxième entrée-sortie 25b du sixième coupleur, ceci grâce à la combinaison des deux signaux entrés par les deuxième et troisième entrées-sorties 25b et 25c. Le septième coupleur 26 appliquant la même opération que le sixième coupleur 25 sur des signaux d'entrée identiques, c'est également un signal S_{FI}^{90°} qui sort de la première entrée-sortie 26a du sixième coupleur. Les signaux S_{FI/IM} ont été éliminés grâce à la recombinaison des signaux sensiblement de même puissance S_{FI/IM}^{90°} et S_{FI/IM}^{-90°} en opposition de phase. Le mélangeur 9 opère donc une réjection de la fréquence image lors de la phase de réception.

Enfin, les signaux S_{FI}^{90°} issus des premières entrées-sorties 25a et 26a des sixième et septième coupleurs sont recombinés dans le huitième coupleur 27. Ces deux signaux sont reçus par les première et deuxième entrées-sorties 27a et 27b du huitième coupleur 27 et se combinent pour sortir sur la sortie 9c du mélangeur 9.

En résumé, le signal S_{RF}+S_{IM} entrant sur l'entrée-sortie 9a du mélangeur 9 combiné avec le signal S_{FOL} entrant sur la première entrée 9b du mélangeur 9 produit le signal S_{FI}^{90°} sortant sur la sortie 9c du mélangeur 9. Des composantes fréquentielles Fol, RF et RF+Fol issues des cellules de mélanges 19, 20 21, 22, puis transmises en sortie 9c peuvent ensuite être aisément filtrées du fait de l'écart important entre ces fréquences et Fl.

Les déphasages sont appliqués à l'aide de trois groupes de coupleurs. Un premier groupe constitué du premier et deuxième coupleur (14, 15) est un premier moyen permettant de déphaser les signaux issus de l'oscillateur local 12. Un deuxième groupe constitué du troisième, quatrième, et cinquième coupleur (16, 17, 18) est un deuxième moyen permettant de déphaser les signaux de fréquence RF. Un troisième groupe constitué du sixième, septième et huitième coupleurs (25, 26, 27) est un troisième moyen permettant de déphaser les signaux de fréquence FI.

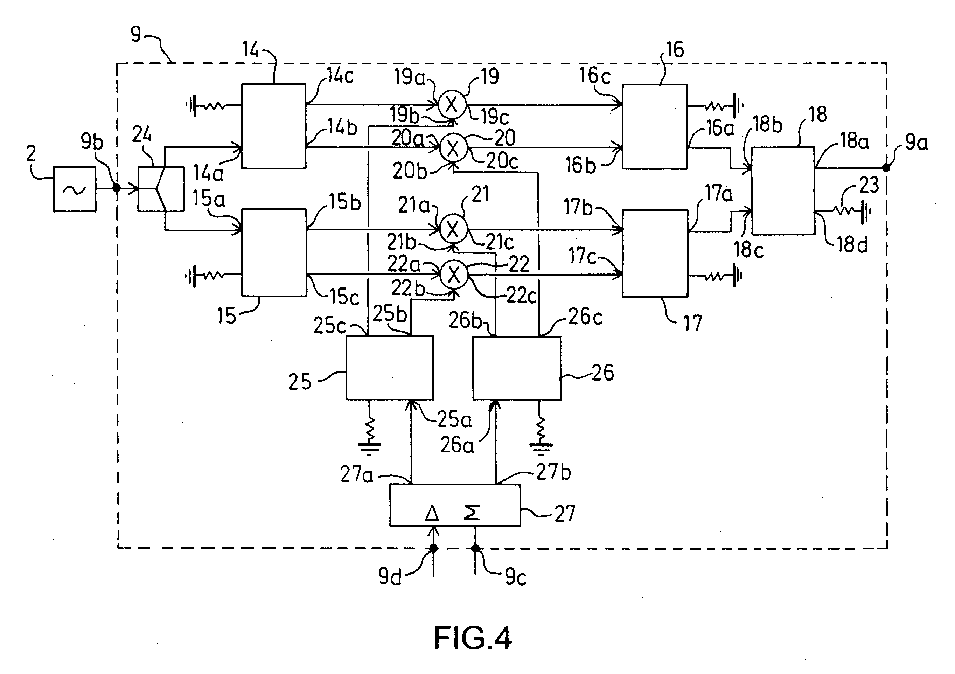

La figure 4 présente un exemple de réalisation de l'invention avec des indications fléchées sur les sens de propagation des signaux correspondant à la phase d'émission.

Lors de cette phase, un signal S_{FI} est adressé au mélangeur par sa deuxième entrée 9d. Le huitième coupleur 27 répartit ensuite le signal S_{FI} sur ses première et deuxième entrées-sorties 27a et 27b. Le signal S_{FI}^{180°} issu de la première entrée-sortie 27a du huitième coupleur 27 est déphasé de 180° par rapport au signal d'entrée S_{FI}, tandis que le signal S_{FI}^{0°} issu de la deuxième entrée-sortie 27b du huitième coupleur 27 n'est pas déphasé. Le signal S_{FI}^{180°} passe ensuite dans le sixième coupleur 25 via sa première entrée-sortie 25a et le signal S_{FI}0° entre dans le septième coupleur 26 par sa première entrée-sortie 26a. A l'issue du passage dans ces deux coupleurs 25 et 26, les signaux S_{FI}^{180°} et S_{FI}^{0°} sont chacun de nouveau divisés en deux signaux. Les signaux S_{FI}^{180°} et S_{FI}^{0°} issus des deuxièmes entrées-sorties 25b et 26b des sixième et septième coupleur 25 et 26 ne sont pas déphasés tandis que les signaux S_{FI}^{-90°} et S_{FI}^{90°} issus respectivement des troisième entrées-sorties 25c et 26c des sixième et septième coupleur sont déphasés de 90°. Comme décrit précédemment pour la phase de réception, les sixième et septième coupleurs 25 et 26 sont liés aux cellules de mélange 19, 20, 21, 22. Le signal initial S_{FI} arrivant sur la deuxième entrée 9d du mélangeur 9 est ainsi réparti sur les deuxièmes accès 19b, 22b, 21 b, 20b des cellules de mélange 19, 22, 21, 20 avec une différence de phase de 90° entre chaque voie successive :
o sur le deuxième accès 19b de la première cellule de mélange 19, un signal S_{FI}^{-90°} de fréquence FI déphasé de -90°,
o sur le deuxième accès 22b de la quatrième cellule de mélange 22, un signal S_{FI}^{180°} de fréquence FI déphasé de 180°,
o sur le deuxième accès 21 b de la troisième cellule de mélange 21, un signal S_{FI}^{0°} de fréquence FI non déphasé,
o sur le deuxième accès 20b de la deuxième cellule de mélange 20, un signal S_{FI}^{90°} de fréquence FI déphasé de 90°.

En parallèle, l'oscillateur local délivre, comme pour la phase de réception, un signal S_{FOL} de fréquence Fol qui est transmis et déphasé par les premier et deuxième coupleurs 14 et 15. Chaque cellule de mélange reçoit alors deux signaux de fréquences FI et Fol, mais chacune avec une combinaison de phases différente. En effet,
o la première cellule 19 de mélange combine S_{FI}^{-90°} sur le deuxième accès 19b avec S_{FOL}^{90°} sur le premier accès 19a,
o la deuxième cellule 20 de mélange combine S_{FI}^{90°} sur le deuxième accès 20b avec S_{FOL}^{0°} sur le premier accès 20a,
o la troisième cellule 21 de mélange combine S_{FI}^{0°} sur le deuxième accès 21 b avec S_{FOL}^{0°} sur le premier accès 21 a,
o la quatrième cellule 22 de mélange combine S_{FI}^{180°} sur le deuxième accès 22b avec S_{FOL}^{90°} sur le premier accès 22a.
Selon le fonctionnement d'une cellule de mélange décrit plus haut, les composantes fréquentielles en sortie des cellules de mélange sont FI, Fol, IM=Fol-FI, et RF=FI+Fol. Les composantes FI, Fol, et IM sont indésirables. La composante FI peut être filtrée aisément ultérieurement du fait de l'écart important entre FI et RF, elle sera donc ignorée dans la suite de la description. Par contre, les composantes Fol et IM sont potentiellement assez proches de RF pour notamment gêner un filtrage passe-bande autour de RF. Il faut donc les supprimer.
Ainsi, en sortie des cellules de mélange, on obtient :
o sur le troisième accès 19c de la première cellule de mélange 19, S_{FI+Fol}^{-90°+90°}+S_{Fol-FI}^{90°-(-90)°}+S_{Fol}^{90°} = S_{RF}^{0°}+S_{IM}^{180°}+S_{Fol}^{90°},
o sur le troisième accès 20c de la deuxième cellule de mélange 20, S_{FI+Fol}^{90°+0°}+S_{Fol-FI} ^{0°-90°}+S_{Fol}^{0°} = S_{RF}^{90°}+SM^{-90°}+S_{Fol}^{0°},
o sur le troisième accès 21 c de la troisième cellule de mélange 21, S_{FI+Fol}^{0°+0°}+S_{Fol-FI}^{0°-0°}+S_{Fol}0°=S_{RF}^{0°}+S_{IM}^{0°}+S_{Fol}^{0°}
o sur le troisième accès 22c de la quatrième cellule de mélange 22, S_{FI+Fol}^{180°+90°}+S_{Fol-FI}^{90°-180°}+S_{Fol}^{90°}=S_{RF}-^{90°}+S_{IM}^{-90°}+S_{Fol}^{90°}

Suivant le même principe qu'en phase de réception, les signaux sont recombinés dans les troisième, quatrième et cinquième coupleurs 16, 17 et 18.
Le signal S_{RF}^{0°}+S_{IM}^{180°}+S_{Fol}^{90°} sortant du troisième accès 19c de la première cellule de mélange 19, est transmis au troisième coupleur 16 via sa troisième entrée-sortie16c et est déphasé de 90°. Le signal S_{RF}^{90°}+S_{IM}^{-90°}+S_{Fol}^{0°} sortant du troisième accès 20c de la deuxième cellule de mélange 20 n'est pas déphasé. Le troisième coupleur 16 opère donc la combinaison suivante :
(S_{RF}^{0°+90°}+S_{IM}^{180°+90°}+S_{Fol}^{90°+90°}) + (S_{RF}^{90°}+S_{IM}^{-90°}+S_{Fol}^{0°}) et le signal issu de la première entrée-sortie 16a du troisième coupleur 16 est donc S_{RF}^{90°}+S_{IM}^{-90°}, avec une puissance sensiblement égale à la somme des puissances d'entrée. La composante Fol a été éliminé grâce à la combinaison de signaux en opposition de phase de puissances approximativement égales S_{Fol}^{180°} et S_{Fol}^{0°}. Le même principe opère dans le quatrième coupleur 17 avec la combinaison suivante :
(S_{RF}^{0°}+S_{IM}^{0°}+S_{Fol}^{0°}) + (S_{RF}^{-90°+90}°+S_{IM}^{-90°+90°}+S_{Fol}^{90°+90°}). Le signal issu de la première entrée-sortie 17a du troisième coupleur 17 est donc S_{RF}^{0°}+S_{IM}^{0°}, avec une puissance sensiblement égale à la somme des puissances d'entrée. Là encore, la combinaison des signaux d'entrée aboutit à une réjection de la fréquence Fol en sortie.

Les deux signaux issus de des premières entrées-sorties 16a et 17a des troisième et quatrième coupleurs 16 et 17 sont ensuite recombinés dans le cinquième coupleur 18 en passant respectivement par les deuxième et troisième entrées-sorties 18b et 18c. La combinaison suivante est alors effectuée :
(S_{RF}^{90°}+S_{IM}^{-90°}) + (S_{RF}^{0°+90°}+S_{IM}^{0°+90°}). Les puissances sur les deuxième et troisième entrées-sorties 18b et 18c du cinquième coupleur 18 étant sensiblement équivalentes, le cinquième coupleur 18 opère une réjection de la fréquence image en combinant les deux composantes S_{IM}^{-90°} et S_{Im}^{90°} en opposition de phase. Le signal issu de sa première entrée-sortie18a est donc S_{RF}^{90°}_{.}

En résumé, le signal S_{IF} entrant sur la deuxième entrée 9d du mélangeur 9 combiné avec le signal S_{FOL} entrant sur la première entrée 9b du mélangeur 9 produit le signal S_{RF}^{90°}sortant sur l'entrée-sortie 9a du mélangeur 9. Les composantes fréquentielles Fol et IM issues des cellules de mélanges sont donc éliminées grâce à des combinaisons judicieuses de signaux en opposition de phase. La fréquence FI issue des cellules de mélange et transmise en entrée-sortie 9a peut ensuite être aisément filtrée du fait de l'écart important entre RF et FI.

Selon un autre mode de réalisation, l'oscillateur local 12 peut délivrer une fréquence Fol égale à RF+FI. Dans ce cas, la transposition en fréquences opérée par le mélangeur permet, là encore, d'obtenir un signal de fréquence FI en sortie, mais la fréquence image à éliminer est égale à Fol+FI et non plus à Fol-FI. L'architecture du mélangeur reste valide dans cette variante. En effet, il faut simplement adapter les coupleurs à la fréquence Fol et permuter les connexions aux première et quatrième entrées-sorties 18d et 18a du cinquième coupleur de manière à faire passer le signal RF par la quatrième entrée-sortie 18d. De préférence, une fréquence Fol égale à RF-FI est choisie car il est généralement plus facile de gérer des fréquences plus petites.

Un avantage de l'invention est d'opérer directement la réjection d'image directement dans le mélangeur. Cela évite d'ajouter un filtre, toujours pénalisant en taille sur un circuit et parfois même impossible à intégrer sur un MMIC.

Un autre avantage de l'invention est de donner au mélangeur une linéarité en puissance plus importante. En effet, chaque cellule de mélange est sujet au phénomène de saturation de la puissance de sortie lorsque la puissance d'entrée devient trop grande et perd alors sa caractéristique linéaire. Chaque cellule de mélange est notamment caractérisée par sa puissance de sortie au point de compression à 1dB. Pour rappel, le point de compression à 1dB est, sur une courbe représentant la puissance de sortie en fonction de la puissance d'entrée, le point pour lequel l'écart entre la puissance de sortie et son extrapolation linéaire est de 1dB. Un mélangeur comportant quatre cellules de mélange 19, 20, 21 et 22 de même point de compression à 1 dB en parallèle, a un point de compression à 1 dB plus élevé que celui de chacune des cellules prise isolément, grâce à la recombinaison des puissances dans les coupleurs de sortie 25, 26 et 27 en réception et dans les coupleurs 16,17 et 18 en émission.

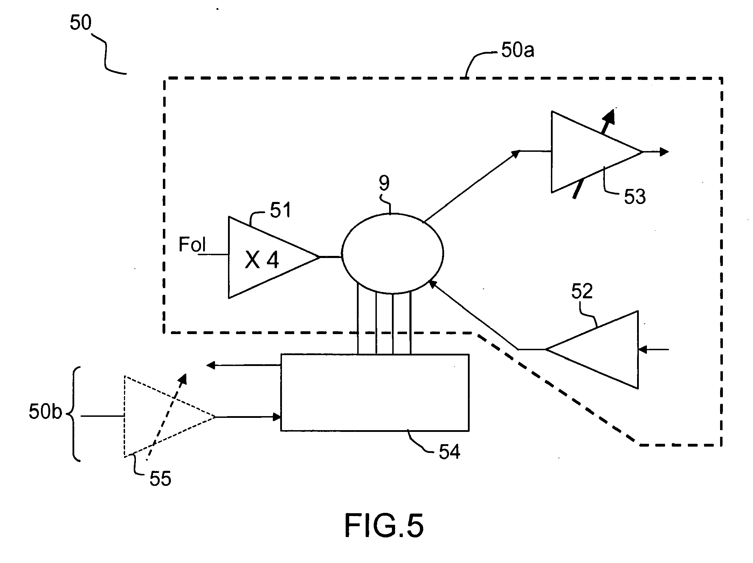

La figure 5 schématise un exemple d'un circuit incorporant un mélangeur unique pour une application de communication en gamme millimétrique.

Le circuit 50 comporte un mélangeur 9 de fréquences bidirectionnel, un multiplieur de fréquence 51, un amplificateur faible bruit 52, un premier amplificateur 53 contrôlé par tension, un composant de couplage 54, et un deuxième amplificateur 55 contrôlé par tension.

Le circuit 50 est composé de deux parties principales. La première partie 50a regroupant le mélangeur 9, l'amplificateur faible bruit 52, le premier amplificateur 53 contrôlé par tension, et le multiplieur de fréquence 51. La deuxième partie 50b comprend le composant de couplage 54 et le deuxième amplificateur 55 contrôlé par tension.

La première partie 50a comporte des éléments qui opèrent à des fréquences en bande millimétrique, ce qui permet d'intégrer cette partie du circuit dans un MMIC. Le mélangeur 9 est relié au multiplieur de fréquences 51 recevant un signal produit par un oscillateur local, relié à l'amplificateur faible bruit 52 recevant un signal d'antenne, relié au premier amplificateur 53 contrôlé par tension permettant d'amplifier des signaux à émettre, et relié au composant de couplage 54. Par ailleurs, le composant de couplage 54 reçoit des signaux à la fréquence intermédiaire FI à travers le deuxième amplificateur 55 contrôlé par tension, et il transmet également des signaux à la fréquence FI.

Le composant de couplage 54 comporte les sixième, septième, et huitième coupleurs 25, 26, 27 fonctionnant à la fréquence intermédiaire FI. Dans l'exemple décrit, la fréquence FI est égale à 5 GHz. Cette fréquence est trop basse pour pouvoir placer la deuxième partie 50b plus volumineuse en circuit intégré, c'est pourquoi les éléments constitutifs de la deuxième partie 50b seront par exemple réalisés à partir de composants discrets ou de lignes réparties sur circuit imprimé.

## Revendications

1. Mélangeur de signaux bidirectionnel adapté à fonctionner selon deux modes :
o un mode réception, combinant un signal radioélectrique S_{RF+IM} comprenant une composante fréquentielle RF et une composante fréquentielle image IM avec un signal S_{FOL} de fréquence F_{OL} pour produire un signal S_{FI} de fréquence intermédiaire FI,
o un mode émission, combinant un signal S_{FI} de fréquence intermédiaire FI avec un signal S_{FOL} de fréquence F_{OL} pour produire un signal radioélectrique S_{RF},
le mélangeur comportant au moins :
o quatre cellules de mélange (19, 20, 21, 22), chacune étant adaptée à combiner deux signaux pour produire un signal de sortie transposé en fréquences par rapport au premier des deux signaux,
o un premier moyen de déphasage (14, 15) adapté à répartir le signal S_{FOL} sur chaque cellule de mélange,
o un deuxième moyen de déphasage (16, 17, 18) adapté, en réception, à répartir la puissance du signal S_{RF+IM} sur chaque cellule de mélange,
o un troisième moyen de déphasage (25, 26, 27) adapté, en réception, à combiner les signaux issus desdites cellules de mélange pour produire un signal S_{FI} exempt de la composante fréquentielle IM, les signaux combinés comprenant des composantes fréquentielles image IM en opposition de phase et des composantes fréquentielles FI en phase,
le troisième moyen de déphasage étant également adapté, en émission, à répartir la puissance du signal S_{FI} sur chaque cellule de mélange, et, le deuxième moyen de déphasage étant également adapté, en émission, à combiner les signaux issus desdites cellules de mélange pour produire un signal radioélectrique S_{RF} exempt de la composante fréquentielle F_{OL}, les signaux combinés comprenant des composantes fréquentielles F_{OL} en opposition de phase et des composantes fréquentielles RF en phase.

2. Mélangeur de signaux bidirectionnel selon la revendication 1, **caractérisé en ce que** le premier moyen de déphasage comporte au moins un coupleur adapté à répartir la puissance d'un signal d'entrée sur deux signaux de sortie, le premier signal de sortie S_{FOL}^{90°} étant déphasé par rapport au second signal de sortie S_{FOL}^{0°}.

3. Mélangeur de signaux bidirectionnel selon l'une des revendications précédentes, **caractérisé en ce que** la premier moyen de déphasage comporte un diviseur de puissance (24) et deux coupleurs (14, 15), ledit diviseur répartissant la puissance du signal S_{FOL} sur une entrée de chaque coupleur, chaque coupleur répartissant la puissance de son signal entrant sur deux signaux de sortie, le premier signal de sortie S_{FOL}^{90°} étant déphasé par rapport au second signal S_{POL}^{0°} de sortie.

4. Mélangeur de signaux bidirectionnel selon l'une des revendications précédentes, **caractérisé en ce que** le deuxième moyen de déphasage comporte au moins trois coupleurs (16, 17, 18), une première entrée-sortie (18b) du premier coupleur étant reliée à une entrée-sortie (17a) du deuxième coupleur, et une deuxième entrée-sortie (18c) du premier coupleur étant reliée à une entrée-sortie (17a) du troisième coupleur, les deuxième et troisième coupleur étant reliés aux cellules de mélange, afin de :
o répartir, en sortie des deuxième et troisième coupleur, la puissance du signal S_{RF+IM} reçu par une entrée-sortie (18a) du premier coupleur,
o et/ou combiner les signaux reçus par les deuxième et troisième coupleur pour produire un signal S_{RF} sur une entrée-sortie (18a) du premier coupleur.

5. Mélangeur de signaux bidirectionnel selon l'une des revendications précédentes, **caractérisé en ce que** la troisième moyen de déphasage comporte au moins trois coupleurs (25, 26, 27), une première entrée-sortie (27a) du premier coupleur étant reliée à une entrée-sortie (25a) du deuxième coupleur, et une deuxième entrée-sortie (27b) du premier coupleur étant reliée à une entrée-sortie (26a) du troisième coupleur, les deuxième et troisième coupleur étant reliés aux cellules de mélange, afin de:
o répartir, en sortie des deuxième et troisième coupleur, la puissance du signal S_{FI} reçu par une entrée-sortie (9d) du premier coupleur,
o et/ou combiner des signaux reçus par les deuxième et troisième coupleur pour produire un signal S_{FI} sur une entrée-sortie (9c) du premier coupleur.

6. Système émetteur/récepteur radiofréquences (50) comportant au moins un mélangeur de signaux bidirectionnel selon l'une des revendications 1 à 5.

## Claims

1. A bidirectional signal mixer designed to operate in two modes:
- a receiving mode, combining a radioelectric signal S_{RF+IM} including a frequency component RF and an image frequency component IM with a signal S_{FOL} of frequency F_{OL} to produce a signal S_{FI} of intermediate frequency F_{I},
- an emitting mode, combining a signal S_{FI} of intermediate frequency FI with a signal S_{FOL} of frequency F_{OL} to produce a radioelectric signal S_{RF},
the mixer comprising at least:
- four mixing cells (19, 20, 21, 22), each being designed to combine two signals to produce an output signal translated in to frequencies relative to the first of the two signals,
- a first phase shifting means (14, 15) designed to distribute the signal S_{FOL} to each mixing cell,
- a second phase shifting means (16, 17, 18) designed, in receiving mode, to distribute the power of signal S_{RF+IM} to each mixing cell,
- a third phase shifting means (25, 26, 27) designed, in receiving mode, to combine the signals originating from said mixing cells to produce a signal S_{FI} which is free from the frequency component IM, the combined signals including opposing-phase image frequency components IM and in-phase frequency components FI,
the third phase shifting means further being designed, in emitting mode, to distribute the power of signal S_{FI} to each mixing cell, and the second phase shifting means further being designed, in emitting mode, to combine the signals originating from said mixing cells to produce a radioelectric signal S_{RF} which is exempt from the frequency component F_{OL}, the combined signals including opposing-phase image frequency components F_{OL} and in-phase frequency components RF.

2. The bidirectional signal mixer according to claim 1, **characterised in that** the first phase shifting means includes at least one coupler designed to distribute the power of an input signal to two output signals, the first output signal S_{FOL}^{90°} being phase shifted relative to the second output signal S_{FOL}^{0°}.

3. The bidirectional signal mixer according to any one of the previous claims, **characterised in that** the first phase shifting means include a power divider (24) and two couplers (14, 15), said divider distributing the power of signal S_{FOL} to an input of each coupler, each coupler distributing the power of its input signal to two output signals, the first output signal S_{FOL}^{90°} being phase shifted relative to the second output signal S_{FOL}^{0°}.

4. The bidirectional signal mixer according to any one of the previous claims, **characterised in that** the second phase shifting means include at least three couplers (16, 17, 18), a first input-output (18b) of the first coupler being connected to an input-output (17a) of the second coupler, and a second input-output (18c) of the first coupler being connected to an input-output (17a) of the third coupler, the second and third couplers being connected to the mixing cells in order to:
- distribute, at the output of the second and third couplers, the power of signal S_{RF+IM} received by an input-output (18a) of the first coupler,
- and/or combine the signals received by the second and third couplers to produce a signal S_{RF} on an input-output (18a) of the first coupler.

5. The bidirectional signal mixer according to any one of the previous claims, **characterised in that** the third phase shifting means include at least three couplers (25, 26, 27), a first input-output (27a) of the first coupler being connected to an input-output (25a) of the second coupler, and a second input-output (27b) of the first coupler being connected to an input-output (26a) of the third coupler, the second and third couplers being connected to the mixing cells in order to:
- distribute, at the output of the second and third couplers, the power of signal S_{FI} received by an input-output (9d) of the first coupler,
- and/or combine the signals received by the second and third couplers to produce a signal S_{FI} on an input-output (9c) of the first coupler.

6. A system for emitting/receiving radiofrequencies (50) including at least one bidirectional signal mixer according to any one of claims 1 to 5.

## Patentansprüche

1. Bidirektionaler Signalmixer, der für den Betrieb in zwei Modi ausgelegt ist:
- einem Empfangsmodus, in dem ein radioelektrisches Signal S_{RF+IM} mit einer Frequenzkomponente RF und einer Bildfrequenzkomponente IM mit einem Signal S_{FOL} der Frequenz F_{OL} kombiniert wird, um ein Signal S_{FI} der Zwischenfrequenz FI zu erzeugen,
- einem Emissionsmodus, in dem ein Signal S_{FI} der Zwischenfrequenz FI mit einem Signal S_{FOL} der Frequenz F_{OL} kombiniert wird, um ein radioelektrisches Signal S_{RF} zu erzeugen,
wobei der Mixer wenigstens Folgendes umfasst:
- vier Mischzellen (19, 20, 21, 22), jede so ausgelegt, dass sie zwei Signal kombiniert, um ein Ausgangssignal zu erzeugen, das in Frequenzen in Bezug auf das erste der beiden Signale transponiert ist,
- einen ersten Phasenschieber (14, 15) zum Verteilen des Signals S_{FOL} auf jede der Mischzellen,
- einen zweiten Phasenschieber (16, 17, 18), um im Empfangsmodus die Leistung des Signals S_{RF+IM} auf jede der Mischzellen zu verteilen,
- einen dritten Phasenschieber (25, 26, 27), um im Empfangsmodus die von den Mischzellen kommenden Signale zu kombinieren, um ein Signal S_{FI} zu erzeugen, das frei von der Frequenzkomponente IM ist, wobei die kombinierten Signals gegenphasige Bildfrequenzkomponenten IM und gleichphasige Frequenzkomponenten FI enthalten,
wobei der dritte Phasenschieber ebenfalls so ausgelegt ist, dass er im Emissionsmodus die Leistung des Signals S_{FI} auf jede der Mischzellen verteilt, und der zweite Phasenschieber ebenfalls so ausgelegt ist, dass er im Emissionsmodus die von den Mischenzellen kommenden Signale kombiniert, um ein radioelektrisches Signal S_{RF} zu erzeugen, das frei von der Frequenzkomponente F_{OL} ist, wobei die kombinierten Signale gegenphasige Bildfrequenzkomponenten F_{OL} und gleichphasige Frequenzkomponenten RF enthalten.

2. Bidirektionaler Signalmixer nach Anspruch 1, **dadurch gekennzeichnet, dass** der erste Phasenschieber wenigstens einen Koppler zum Verteilen der Leistung eines Eingangssignals auf zwei Ausgangssignale aufweist, wobei das erste Ausgangssignal S_{FOL}^{90°} in Bezug auf das zweite Ausgangssignal S_{FOL}^{0°} phasenverschoben ist.

3. Bidirektionaler Signalmixer nach einem der vorherigen Ansprüche, **dadurch gekennzeichnet**, der erste Phasenschieber einen Leistungsteiler (24) und zwei Koppler (14, 15) aufweist, wobei der Teiler die Leistung des Signals S_{FOL} auf einen Eingang jedes Kopplers verteilt, wobei jeder Koppler die Leistung seines Eingangssignals auf zwei Ausgangssignale verteilt, wobei das erste Ausgangssignal S_{FOL}^{90°} in Bezug auf das zweite Ausgangssignal S_{FOL}^{0°} phasenverschoben ist.

4. Bidirektionaler Signalmixer nach einem der vorherigen Ansprüche, **dadurch gekennzeichnet, dass** der zweite Phasenschieber wenigstens drei Koppler (16, 17, 18) aufweist, wobei ein erster Ein-/Ausgang (18b) des ersten Kopplers mit einem Ein-/Ausgang (17a) des zweiten Kopplers verbunden ist und ein zweiter Ein-/Ausgang (18c) des ersten Kopplers mit einem Ein-/Ausgang (17a) des dritten Kopplers verbunden ist, wobei der zweite und der dritte Koppler mit den Mischzellen verbunden sind, um:
- am Ausgang des zweiten und des dritten Kopplers die Leistung des von einem Ein-/Ausgang (18a) des ersten Kopplers empfangenen Signals S_{RF+IM} zu verteilen,
- und/oder die vom zweiten und vom dritten Koppler empfangenen Signale zu kombinieren, um ein Signal S_{RF} an einem Ein-/Ausgang (18a) des ersten Kopplers zu erzeugen.

5. Bidirektionaler Signalmixer nach einem der vorherigen Ansprüche, **dadurch gekennzeichnet, dass** der dritte Phasenschieber wenigstens drei Koppler (25, 26, 27) aufweist, wobei ein erster Ein-/Ausgang (27a) des ersten Kopplers mit einem Ein-/Ausgang (25a) des zweiten Kopplers verbunden ist und ein zweiter Ein-/Ausgang (27b) des ersten Kopplers mit einem Ein-/Ausgang (26a) des dritten Kopplers verbunden ist, wobei der zweite und der dritte Koppler mit den Mischzellen verbunden sind, um:
- am Ausgang des zweiten und des dritten Kopplers die Leistung des von einem Ein-/Ausgang (9d) des ersten Kopplers empfangenen Signals S_{FI} zu verteilen,
- und/oder die vom zweiten und vom dritten Koppler empfangenen Signale zu kombinieren, um ein Signal S_{FI} an einem Ein-/Ausgang (9c) des ersten Kopplers zu erzeugen.

6. System zum Senden/Empfangen von Radiofrequenzen (50) mit wenigstens einem bidirektionalen Signalmixer nach einem der Ansprüche 1 bis 5.
